# EUROPÄISCHE PATENTSCHRIFT

(11) **EP 2 899 881 B1**
(45) Veröffentlichungstag und Bekanntmachung des Hinweises auf die Patenterteilung: **03.01.2018**
(21) Anmeldenummer: 14020078.3
(22) Anmeldetag: 08.11.2014
(51) Int. Cl.: H02S 40/34

(54) **PV-Modul, das für höchste Packungsdichte und kostengünstigen Transport optimiert ist und dafür geeignete Modulanschlussdose**
PV-Module optimised for high packing density and low cost shipping
Module photovoltaique optimisé pour une haute densité de conditionnement et côuts réduits de transport

(30) Priorität: 08.11.2013 DE 102013018757
(43) Veröffentlichungstag der Anmeldung: 29.07.2015
(73) Patentinhaber: Naebauer, Anton, 80805 München (DE); Gehrlicher, Klaus, 85540 Haar (DE)
(72) Erfinder: Naebauer, Anton, 80805 München (DE); Gehrlicher, Klaus, 85540 Haar (DE)

(56) Entgegenhaltungen:
- EP-A2- 1 717 866
- WO-A2-2009/129422
- JP-A- H0 992 865
- US-A1- 2011 186 113

## Beschreibung

Die Erfindung betrifft ein PV-Modul nach dem Oberbegriff von Anspruch 1, das für höchste Packungsdichte und kostengünstigen Transport optimiert ist, und ein Verfahren zum Transport wenigstens zweier derartiger PV-Module nach dem Oberbegriff von Anspruch 3.

Photovoltaikmodule waren in den letzten Jahren einem starken Preisverfall unterworfen. Dieser wurde insbesondere auch getrieben durch den Aufbau von großen Fertigungskapazitäten in Ländern mit vergleichsweise geringen Löhnen, wie zum Beispiel China. Da damit die Fertigungskapazitäten weit weg vom Installationsort der PV-Module ist, kommt den Transportkosten eine besondere Bedeutung zu. Aus diesem Grund ist es wichtig, dass die Transportkosten möglichst gering sind.
Werden heute typische gerahmte kristalline PV-Module in einem 40 Fuss High Qube Container transportiert, ist der Container in Bezug auf das Gewicht nur zu ca. 60 % ausgelastet. An diesem Beispiel kann man sehen, dass beim Transport der PV-Module ein großes Kostensenkungspotential vorhanden ist. Ziel muss es also sein, für den Transport die Packungsdichte der Module deutlich zu erhöhen. Anzustreben wäre es einen 20 Fuß Standard Container gewichtsmäßig auszulasten.

Die höchste Packungsdichte wird erreicht, wenn die Module flächenmäßig vollständig aneinander liegen. Bei den weit verbreiteten gerahmten PV-Modulen ist dies nicht möglich, da die Module einen Rahmen besitzen, der meist zwischen 30 und 50 mm hoch ist.

Auch Module ohne Rahmen können nicht dicht Fläche auf Fläche gestapelt werden, da die Module auf der Rückseite eine Anschlussdose besitzen, die viel Raum einnimmt.

Für viele Anwendungen ist es vorteilhaft, wenn die PV-Module statt einer elektrischen Anschlussdose, zwei getrennte Anschlussdosen haben, wobei eine für den Pluspol und eine für den Minuspol vorgesehen ist. Wenn die beiden elektrischen Anschlussdosen an verschiedenen Seiten des Moduls angebracht sind, können hierdurch in vielen Fällen die Kabellängen zu den Nachbarmodulen reduziert werden, und damit Kosten gespart werden und die elektrischen Verluste reduziert werden.

Ein PV-Modul mit den Merkmalen des Oberbegriffs des Anspruchs 1 geht aus dem Dokument WO 2009/129422 A2 hervor.

Der Erfindung liegt die Aufgabe zu Grunde, die Packungsdichte von PV-Modulen mit zwei auf verschiedenen Seiten angebrachten Anschlussdosen zu erhöhen.

Dies wird erfindungsgemäß mit einem PV-Modul mit den Merkmalen des Anspruchs 1 erreicht.

Insbesondere wird dies dadurch erreicht, dass das Modul eine rechteckige Rückwand und eine rechteckige transparente Frontscheibe mit der Ausdehnung X von links nach rechts und der Ausdehnung Y von unten nach oben besitzt, die einen rechten, einen linken, einen unteren und einen oberen Rand besitzt, und bei der ein Zentralpunkt durch die Mitte der Vorderfläche der Frontscheibe definiert ist, und dass zwischen Frontscheibe und Rückwand eine aktive Schicht liegt, in der unter anderem Photovoltaik Zellen eingebaut und elektrisch verschaltet sind, wobei das gesamte Laminat aus Frontscheibe aktiver Schicht und Rückwand eine Dicke Z aufweist und wobei der linke Rand der Frontscheibe in jeweils 4 Bereiche geteilt ist, die von oben nach unten mit 11, 12, 13 und 14 bezeichnet werden und der rechte Rand der Frontscheibe ebenfalls in vier Bereiche geteilt ist, die von oben nach unten mit 21, 22, 23 und 24 bezeichnet werden, wobei die Bereiche 14, 21, und 24 ebenso groß sind wie der Bereich 11, und die Bereiche 13, 22 und 23 ebenso groß sind wie der Bereich 12 und wobei das Modul über eine Anschlussdose für den Pluspol und eine Anschlussdose für den Minuspol verfügt, wobei eine der beiden Dosen in einem der vier linken Randbereiche und die andere der beiden Dosen in einem der vier rechten Randbereiche angeordnet ist und die Anschlussdosen nach rechts und nach links über den Rand der Frontscheibe hinausragen, und wobei die beiden Dosen in den Bereichen 11 und 22 oder 11 und 23 oder 12 und 21 oder 12 und 24 oder 13 und 21 oder 13 und 24 oder 14 und 22 oder 14 und 23 in Kombination auftreten können.

Mehrere derartig aufgebaute Module können sehr platzsparend direkt aufeinander gestapelt werden, wenn jeweils vier unmittelbar aufeinanderliegende Module unterschiedlich ausgerichtet sind, wie dies in den Verfahrensansprüchen 3 bis 5 angegeben ist.

Im Folgenden wird die Erfindung beispielhaft anhand der beiliegenden Figuren erläutert. Es zeigen:
- Fig. 1:: Einteilung des rechten und linken Randes der Frontscheibe in jeweils 4 Bereiche, wobei die Bereiche 14, 21 und 24 ebenso groß sind wie Bereich 11 und die Bereiche 13, 22 und 23 ebenso groß sind wie Bereich 12.
- Fig. 2:: Acht Kombinationsmöglichkeiten (K1 ...K8) wie die beiden rechts und links über die rechteckige Modulfläche hinausragenden Moduldosen erfindungsgemäß am PV-Modul in angebracht werden können.
- Fig. 3:: Darstellung der 4 Ausrichtungen (A, B, C, D) eines Module und beispielhafte Möglichkeit wie Module mit diesen 4 Ausrichtungen aufeinander gestapelt werden können auf Basis von K3.
- Fig. 4:: Darstellung der 4 Ausrichtungen (A, B, C, D) eines Module und beispielhafte Möglichkeit wie Module mit diesen 4 Ausrichtungen aufeinander gestapelt werden können auf Basis von K4.
- Fig. 5:: Frontansicht von Modul sowie Schnitt (A - A) davon durch linke Anschlussdose mit Rumpfbereich der Dicke BZ und Überstandsbereich der Dicke OZ
- Fig. 6:: Frontansicht von Modul sowie Schnitt (A - A) davon durch linke Anschlussdose die in den Übergangsbereich hineinreicht wobei der Überlappungsbereich 4cd nicht hinter die Rückwand hinausragt.
- Fig. 7:: Frontansicht von Modul sowie Schnitt (A - A) davon durch linke Anschlussdose die in den Übergangsbereich hineinreicht wobei der Überlappungsbereich 4cd über die Rückwand hinausragt und wobei im Schnittbild zusätzlich ein weiteres Modul auf der Rückseite angelegt ist.
- Fig. 8:: Detailbild (Schnittbild) von Anschlussdose mit Übergangsbereich mit zweitem an Rückwand anliegendem Modul

### Bezugszeichenliste:

- 1: Modul Frontscheibe
- 2: Modul Rückwand
- 3: Übergangsbereich und dessen Ausdehnung
- 4: Anschlussdose
- 4a: Rumpfbereich der Anschlussdose mit Dicke BZ kleiner als Dicke von Modulquartett
- 4b: Überstandsbereich der Anschlussdose
- 4cd: Überlappungsbereich der Anschlussdose
- 4c: Randnaher Teil des Überlappungsbereichs
- 4d: Überlappungsbereich angrenzend an Rückwand
- 5: Aktive Schicht
- 6: Trennblatt
- 7: Zentralpunkt (Mittelpunkt der Vorderseite der rechteckigen Frontscheibe)
- 8: Ausdehnung des Überstandbereichs 4b
- 11: vertikaler Bereich am linken Rand der Frontscheibe beginnend oben
- 12: vertikaler Bereich am linken Rand der Frontscheibe anschließend unter Bereich 11
- 13: vertikaler Bereich am linken Rand der Frontscheibe anschließend unter Bereich 12 und ebenso groß wie Bereich 12
- 14: vertikaler Bereich am linken der Frontscheibe anschließend unter Bereich 13 und ebenso groß wie Bereich 11
- 21: vertikaler Bereich am rechten Rand der Frontscheibe beginnend oben und ebenso groß wie Bereich 11
- 22: vertikaler Bereich am rechten Rand der Frontscheibe anschließend unter Bereich 21 und ebenso groß wie Bereich 12
- 23: vertikaler Bereich am rechten Rand der Frontscheibe anschließend unter Bereich 22 genauso groß wie Bereich 13
- 24: vertikaler Bereich am rechten Rand der Frontscheibe anschließend unter Bereich 23 genauso groß wie Bereich 14
- 30: Kabelabführung (Umriss des Kabels)
- 34: Vertikale Mittelachse
- 35: Horizontale Mittelachse
- 101: Frontscheibe von zweitem Modul
- 102: Rückwand von zweitem Modul
- 103: Übergangsbereich von zweitem Modul
- 104: Anschlussdose von zweitem Modul
- 105: Aktive Schicht von zweitem Modul

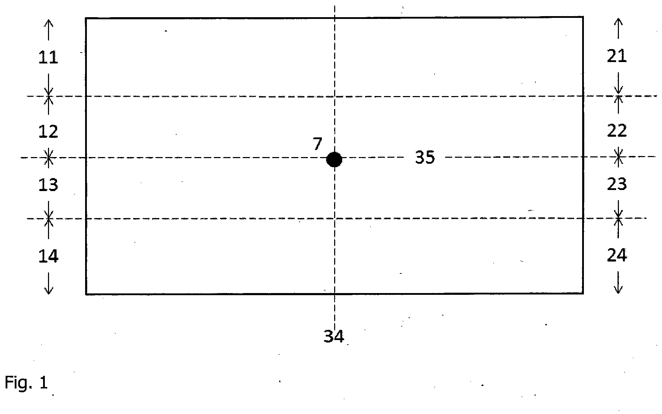

Figur 1 zeigt beispielhaft die Einteilung des rechten und des linken Randes der Frontscheibe in jeweils vier Randbereiche, wobei auf jeder Seite, der oberste Bereich gleich groß ist wie der unterste Bereich und der zweite Bereich von oben genauso groß ist wie der zweite Bereich von unten. Die Modul-Frontscheibe ist bezüglich der Einteilung der Randbereiche symmetrisch zur horizontalen Mittelachse 35, die das Modul in zwei gleiche große Teile teilt (eingezeichnet als Trennungslinie zwischen Bereich 12 und 22 einerseits und Bereich 13 und 23 andererseits). Die Frontscheibe ist auch symmetrisch zur vertikalen Mittelachse 34, die die Frontscheibe in zwei gleichgroße Teile einteilt. Punkt 7 stellt dem Mittelpunkt der Vorderseite der Frontscheibe dar, der gleichzeitig der Schnittpunkt der horizontalen Mittelachse 35 und der vertikalen Mittelachsen 34 ist.

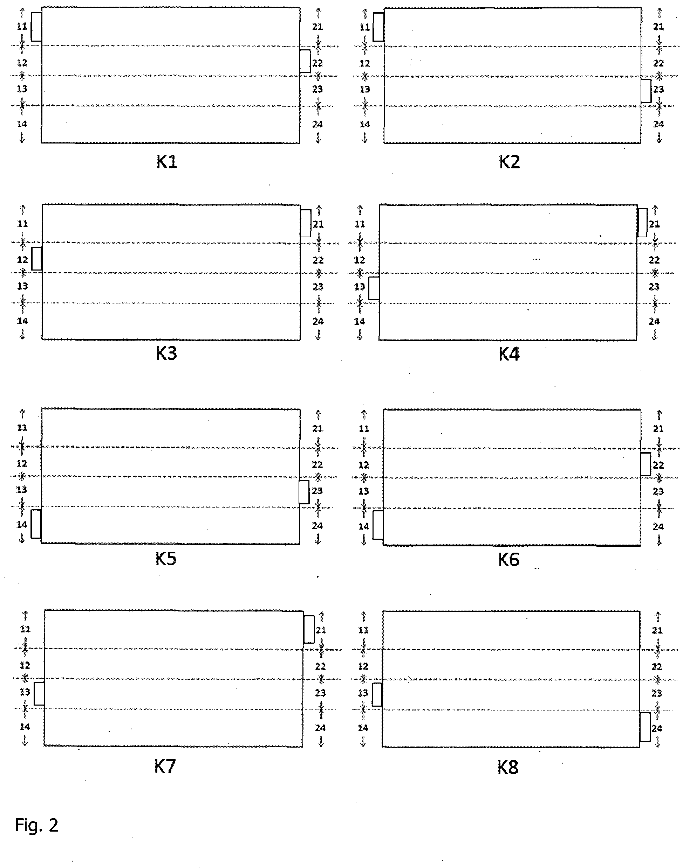

Figur 2 zeigt die 8 erfindungsgemäße Kombinatinsmöglichkeiten (K1 ... K8), wie die über die Modul Frontscheibe (= Modulfläche) hinausragenden Moduldosen angeordnet sein können, damit ein besonders Platz sparendes Stapeln der Module möglich ist.

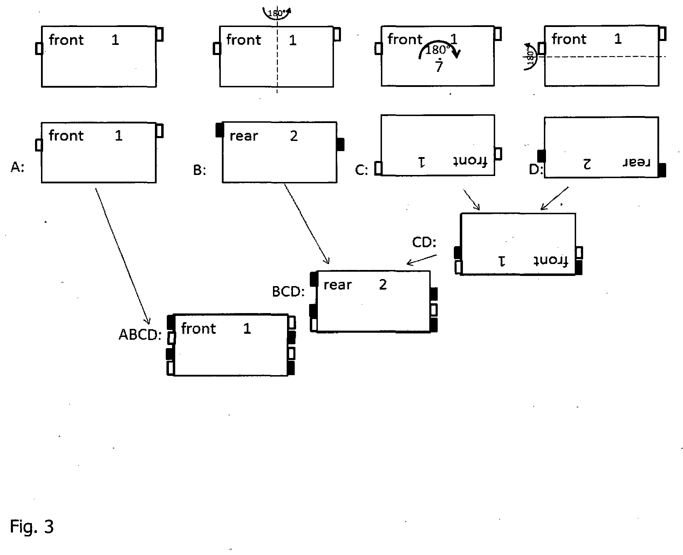

Figur 3 zeigt eine Möglichkeit, wie aus vier unterschiedlich ausgerichteten Modulen ein "Quartett" aufgebaut sein kann, bei dem die Module, Fläche auf Fläche übereinandergelegt sind (gegebenenfalls mit einem Trennblatt zwischen jeweils zwei aneinander liegenden Modulen). Im oberen Teil der Figur werden vier Möglichkeiten (A, B, C, D) der Ausrichtung eines Moduls erklärt, wobei gezeigt wird, durch welche Drehung die jeweilige Modulausrichtung (B, C, D) aus der ursprünglichen Modulausrichtung (A) entsteht. Ausrichtung B entsteht aus Ausrichtung A durch Drehung um 180° um die vertikale Mittelachse, das ist die Achse, die vertikal durch den Zentralpunkt verläuft. Ausrichtung C entsteht aus Ausrichtung A durch eine Drehung um 180 um die Achse, die senkrecht auf der Frontscheibe steht und durch den Zentralpunkt 7 verläuft.

Ausrichtung D entsteht aus Ausrichtung A durch Drehung um 180° um die horizontale Mittelachse.

Ausrichtung D kann auch entstehen aus Ausrichtung B und Drehung um 180 um die Achse, die senkrecht auf der Frontscheibe steht und durch den Zentralpunkt 7 verläuft. Ein Fachmann kann erschließen, wie jede der 4 Ausrichtungen durch jeweils eine Drehung um eine der drei beschriebenen Achsen in eine der anderen Ausrichtungen übergeht. Dies heißt mit anderen Worten, dass es mit den beschriebenen 3 Drehungen genau 4 Ausrichtungen gibt, und auch durch mehrfache Drehungen keine neuen Ausrichtungen erzeugt werden können.

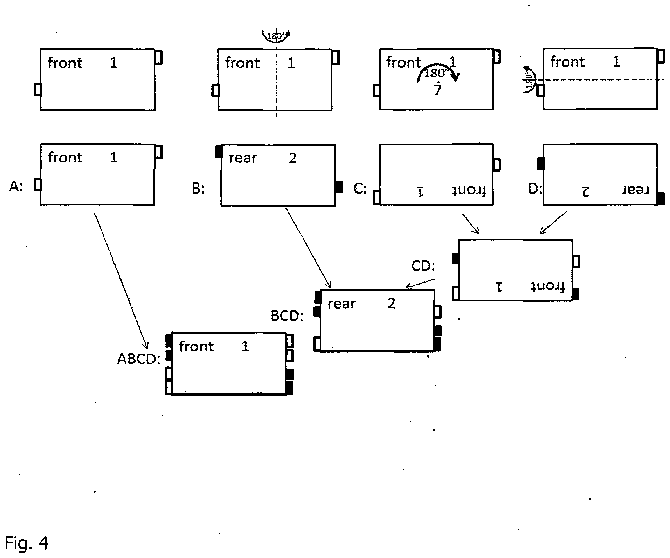

In Figur 3 und Figur 4 gilt, dass eine Moduldose von vorne gesehen weiß ausgefüllt ist, während eine Moduldose von hinten gesehen schwarz ausgefüllt ist. Die Vorderseite des Moduls wird mit 1 (entsprechend der Frontscheibe) bzw. "front" gekennzeichnet, die Rückseite wird mit 2 (entsprechend der Rückwand) bzw. "rear" gekennzeichnet.

Im unteren Teil von Figur 3 ist gezeigt, dass zwei Module mit Ausrichtung C und D aufeinander (CD: von oben nach unten, d. h. C über D) gelegt werden können, ohne dass es zu einer Kollision der Moduldosen kommt.

Ebenso wird gezeigt, dass drei Module mit Ausrichtung B, C und D (von oben nach unten erst B, dann C, dann D) aufeinander gelegt werden können ohne dass es zu einer Kollision der Moduldosen kommt.

Weiterhin wird gezeigt, dass vier Module mit Ausrichtung A, B, C und D aufeinander gelegt werden können ohne dass es zu einer Kollision der Moduldosen kommt. Diese vier Module bilden ein Quartett mit der Folge ABCD, d. h. von oben nach unten erst A, dann B, dann C, dann D.

Es ist einleuchtend, dass mehrere Quartette mit der Folge ABCD übereinander gestapelt werden können, ohne dass es zu einer Kollision der über die Ränder links und rechts hinausragenden Anschlussdosen kommt sofern BZ, die Dicke der Anschlussdose im Rumpfbereich nicht größer ist als die Dicke eines Stapels von vier Modulen. Ein Trennblatt zwischen zwei Modulen hilft, dass aufeinanderliegende Module leichter voneinander getrennt werden können und kann verhindern, dass aufeinanderliegende Glasscheiben durch dazwischenliegende Partikel verkratzt werden. Auch kann ein Trennblatt eine zusätzlich Polsterung bieten und einen Toleranzausgleich bieten für fertigungsbedingte Streuungen der Dicken von Rückwand, aktiver Schicht und Frontscheibe. In den meisten Fällen sollte das Trennblatt eine Dicke zwischen 50 µm und 3000 µm haben.

Das hier beispielhaft gezeigte Quartett ist nur eines von vielen Quartetten, die alle die Eigenschaft haben, dass sie sehr platzsparend ohne Kollision zwischen den Anschlussdosen aufeinander gestapelt werden können. Wesentliches Merkmal jedes Quartetts ist, dass in einem Quartett keine zwei gleich ausgerichteten Module vorkommen oder anders ausgedrückt in jedem Quartett jede der vier definierten Modulausrichtungen vorkommt.

Die Bildung eines beispielhaften Quartetts wurde beispielhaft anhand der Kombinationsmöglichkeit K3 erklärt, bei dem die Anschlussdosen in den Bereichen 12 und 21 angebracht sind. Ein Fachmann kann aufgrund der dargestellten Überlegungen leicht ein Quartett für die anderen erfindungsgemäßen Möglichkeiten der Anordnung der Anschlussdosen an den Rändern erschließen. In Figur 4 ist eine beispielhafte Zusammenstellung eines Quartetts für die Kombinationsmöglichkeit K4 erläutert, wobei der Aufbau parallel zu dem von Figur 3 ist.

Auch hier werden durch die oben beschriebenen Moduldrehungen in Verbindung mit der ursprünglichen Ausrichtungen des Moduls vier Ausrichtungen definiert.

Ein Quartett ist wiederum dadurch definiert, dass vier unterschiedlich ausgerichtete Module aufeinander gestapelt werden. Unter gewissen später beschriebenen Umständen ist es von Vorteil, wenn der Aufbau des Quartetts durch zwei Modulpaare beschrieben werden kann, wobei die Module eines Paares Rückwand an Rückwand angeordnet sind.

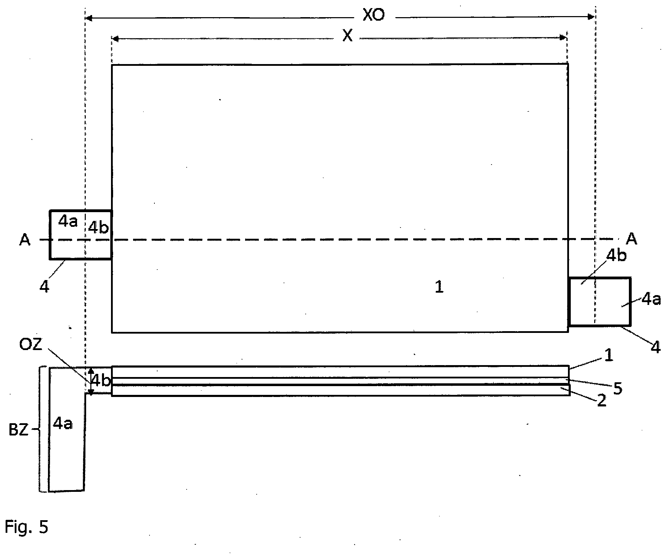

Figur 5 erläutert die Bedeutung der Überstandsbereichs 4b.
Für das einfaches aneinanderlegen der Module ist es weiterhin erforderlich, dass die Anschlussdose 4 aus einem Überstandsbereich 4b, der links (bzw. rechts) direkt an die Frontscheibe anschließt und das Frontglas hinaussteht und weder nach vorne noch nach hinten über das Modul hinaussteht (OZ, die Dicke in diesem Bereich muss kleiner sein als Z, die Dicke des Moduls) und einem daran anschließenden weiter links (bzw. rechts) außen liegendem Rumpfbereich 4a besteht, der mit BZ eine Dicke deutlich größer als die Moduldicke Z haben kann. Durch die geringe Dicke OZ im Überstandsbereich ist sichergestellt dass es im Überstandsbereich nicht zu einer Kollision kommt und die Module auch dann ohne Kollision aneinandergelegt werden können auch wenn die Abmessungen des Moduls bzw. der Frontscheibe durch unvermeidbare Fertigungsstreuungen etwas in der Größe variieren oder die aneinander liegenden Module nicht exakt positioniert sind.

Der Rumpfbereich der Anschlussdose ist auch deshalb deutlich dicker, da hier gegebenenfalls zusätzliche Bauteile, z. B. Bypassdioden untergebracht werden müssen. Der Überstandsbereich 4b liegt links (bzw. rechts) außerhalb der Frontscheibe zwischen dem Rand der Frontscheibe und dem Rumpfbereich. Dies ist in Figur 5 mit verzerrten Maßstäben übertrieben dargestellt.

Wegen unvermeidlicher Fertigungstoleranzen ist es erforderlich, dass XO, der auf die X-Richtung (links -rechts-Richtung) projizierte Abstand zwischen den beiden der Modulmitte zugewandten Außenwänden der Rumpfbereiche 4a der Anschlussdosen, größer ist als die Ausdehnung der Frontscheibe von links nach rechts (X), damit auf der Rückseite ohne Kollision ein Modul angelegt werden kann. Die wird durch den Überstandsbereich 4b sichergestellt.

Aus Gründen der Montage der Anschlussdosen kann es von Vorteil sein, wenn die Anschlussdose nicht erst am Rand der Frontscheibe mit dem Überstandsbereich beginnt, sondern, dass der Teil der Dose, der die Verbindung zu den PV-Zellen in der aktiven Schicht herstellt in einen Übergangsbereich (3) am Modulrand hineinreicht. Dieser Teil der Dose wird als Überlappungsbereich 4bc bezeichnet. Der besagte Übergangsbereich des Moduls kann beispielsweise dadurch gekennzeichnet sein, dass die Frontscheibe des Moduls nach rechts und links größer ist die Rückwand des Moduls. Der Übergangsbereich kann aber auch dadurch gekennzeichnet sein, dass die Rückwand größer ist als die Frontscheibe. Hier wird beispielhaft der Fall angenommen, dass der Übergangsbereich dadurch gekennzeichnet ist, dass die Frontscheibe nach rechts und links über die Rückwand hinausragt. Ein Fachmann kann die erforderlichen Modifikationen erkennen, die erforderlich sind, wenn der Übergangsbereich 3 dadurch definiert ist, dass die Rückwand größer ist als die Frontscheibe. Die Moduldose kann in den Übergangsbereich hineinragen, sofern der in diesen Bereich hineinragende Teil der Anschlussdose - der Überlappungsbereich 4bc - nach hinten nicht über die Rückwand hinausragt.

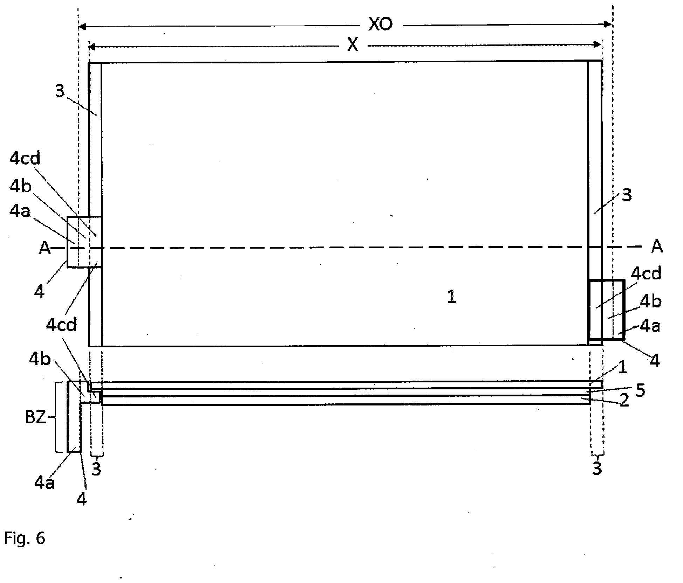

In Figur 6 ist eine Anschlussdose dargestellt, deren Überlappungsbereich nicht nach hinten über die Rückwand hinausragt.
Aufgrund des gewählten Schnittes A - A ist im unteren Schnittbild nur die linke Anschlussdose zu sehen. Gezeigt ist am Beispiel der linken Anschlussdose (4), wie der Überlappungsbereich 4cd in den Übergangsbereich (3) hineinragt, aber gleichzeitig nicht nach hinten über die Rückwand hinausragt. In dieser Figur ist auch die maximale Dicke der Anschlussdose im Rumpfbereich mit BZ bezeichnet. Wegen unvermeidlicher Fertigungstoleranzen ist es erforderlich, dass der auf die X-Richtung (links -rechts-Richtung) projizierte Abstand (XO) zwischen den beiden der Modulmitte zugewandten Außenwänden der Rumpfbereiche der Anschlussdosen, größer ist als die Ausdehnung der Frontscheibe von links nach rechts (X), damit auf der Rückseite ohne Kollision ein Modul angelegt werden kann. Die wird durch den Überstandsbereich 4b sichergestellt.

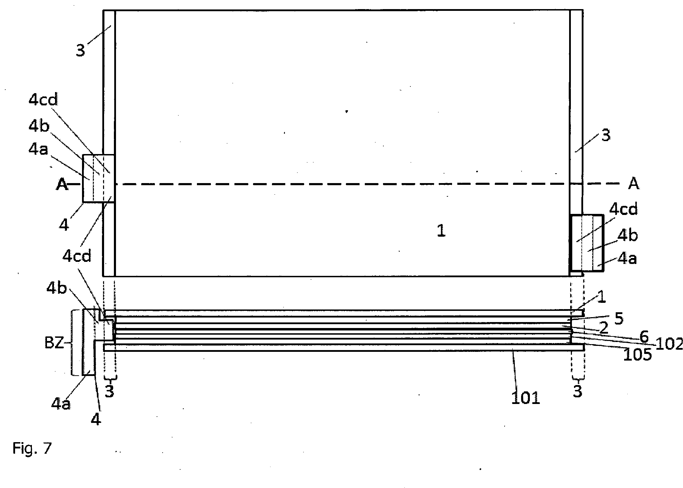

Wenn zwei Module Rückseite an Rückseite optional mit Trennblatt aneinander gelegt werden kann dies den Vorteil haben, das für den Überlappungsbereich mehr Plat zur Verfügung ist. Dies ist in Figur 7 erläutert.

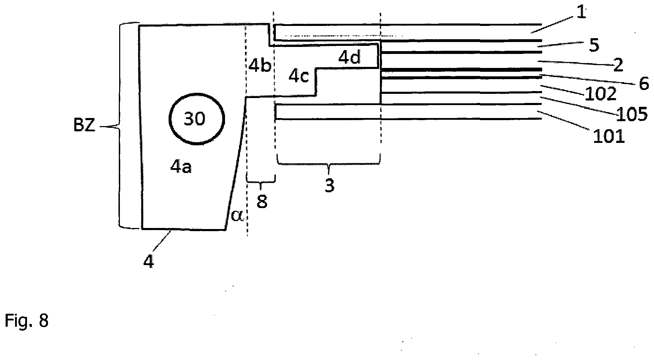

Sofern beim Stapeln immer zwei Module Rückseite auf Rückseite und Vorderseite auf Vorderseite gestapelt werden, kann der Überlappungsbereich der Anschlussdose im Übergangsbereich (3) auch etwas nach hinten über die Rückwand hinausragen, sofern er nicht mehr als die Dicke der Rückwand darüber hinausragt. Dann ist im Übergangsbereich, des an die Rückwand anschließenden Moduls ausreichend Platz dafür, wie in Figur 7 und 8 zu erkennen ist.

Für die Dicke (BZ) der Anschlussdose nach hinten gilt, dass diese geringer sein muss als die die Dicke eines Quartetts mit vier Modulen einschließlich der optionalen Trennblätter.

Die Figuren insbesondere auch Figuren 5, 6, 7 sind nicht maßstabsgerecht, insbesondere sind die Dicke der einzelnen Komponenten (Frontscheibe, Aktive Schicht, Rückwand) deutlich vergrößert im Vergleich zur Ausdehnung des Moduls nach rechts und links, bzw. nach oben und unten. Diese Verzerrungen sind vorsätzlich vorgenommen um die wichtigen Details deutlich sichtbar zu machen.

Figur 8 gibt noch einmal ein detaillierteres Beispiel, wie die linke Dose mit dem Modul verbunden ist. Es ist ein Ausschnitt zu sehen von einem Modulpaar, bei dem zwischen die beiden Rückwände der Module (2, 102) ein Trennblatt (6) eingebracht ist. Die Einzelheiten der Form der Moduldose (4) sind hier deutlicher dargestellt und die Dose ich auch weiter optimiert, unter anderem auch mit dem Ziel, dass Fertigungstoleranzen der Module (Größe der Frontscheibe, Größe der Rückscheibe, Präzision bei Aufeinanderlegen von Frontscheibe und Rückwand, ...) besser berücksichtigt werden. Deutlich sichtbar ist hier der Überstandsbereich 4b, der sicherstellt, dass die über die Frontscheibe rechts und links überstehenden Dosen auf der Hinterseite des Moduls einen größeren Raum anbieten für die Aufnahme des auf der Rückseite anzulegenden Moduls. Die Moduldose 4 besteht aus Rumpfbereich 4a, der eine maximale Dicke von BZ aufweist, sowie aus dem Überstandsbereich 4b und dem Überlappungsbereich (4bc), der eine vergleichsweis geringe Dicke aufweist. Der Überlappungsbereich wiederum besteht aus dem randnahen Teil 4c, in der Nähe des Randes der Frontscheibe und dem an die Rückwand angrenzenden Teil 4d.
Um die variierende Dicke der Anschlussdose, die Ausdehnung der Anschlussdose in Z-Richtung (d. h. nach vorne nach hinten) zu erklären, wird die Dicke und die Dickenänderung beschrieben ausgehend von der Kante der Rückwand nach außen gehend über den randnahen Teil des Überlappungsbereichs und über den Überstandsbereich bis zum Rumpfbereich. Der an die Rückwand angrenzende Teil des Überlappungsbereichs 4d darf nicht nach hinten über die Rückwand 2 hinausstehen um Fertigungsvariationen bei der Größe und Positionierung der Rückwand zu erlauben. Der randnahe Teil des Überlappungsbereichs 4c darf etwas dicker sein, er darf maximal um die Dicke von Rückwand und aktiver Schicht zusammen nach hinten hinausstehen. Die Dicke dieses Bereichs darf als maximal die doppelte Dicke von aktiver Schicht und Rückwand zusammen erreichen. Wenn man weiter hinausgeht in Richtung Rumpfbereich, kann die Dicke des Überlappungsbereichs im randnahen Bereich 4c nach hinten zunehmen. Diese Zunahme kann in einer oder mehreren Stufen oder kontinuierlich oder in einer Kombination von Beidem erfolgen. In Bild 8 erfolgt die Zunahme in einer Stufe an der Grenze von 4c und 4d. Im Bereich des Überstands kann die Dicke des Überstandsbereichs 4b durch eine Stufe nach vorne (um die Dicke der Frontscheibe) zunehmen mit dem Ziel eine möglichst glatte Oberfläche in Verbindung mit der Frontscheibe zu erreichen. Um Kollisionen sicher auszuschließen darf die Dicke des Überstandsbereichs maximal die Dicke des Moduls zuzüglich die Dicke der Rückwand und zuzüglich der Dicke der aktiven Schicht erreichen.

Kleine Unebenheiten oder Zwischenräume, die sich bei der Verbindung zwischen Laminat und Anschlussdose ergeben, werden wie üblich durch Klebstoff oder eine Vergussmasse ausgefüllt, die in den Figuren nicht eingezeichnet ist.
Geht man weiter in zum Rumpfbereich kann die Dicke der Dose dann weiter zunehmen bis zum maximalen Wert, der durch die Dicke eines "Modulquartetts" (einschließlich optionaler Trennblätter) gegeben ist.

Die Zunahme der Dicke im Rumpfbereich kann in einer oder mehreren Stufen oder auch kontinuierlich erfolgen. In Figur 8 ist beispielhaft angenommen dass die Dicke kontinuierlich zunimmt. Hier ist die zur Modulinnenseite weisende Wand der Dose mit dem Winkel α derart abgeschrägt, sodass die Breite (Ausdehnung in X-Richtung) der Anschlussdose nach hinten hin geringer wird. Dadurch wird beim Aneinanderlegen der Module (Rückseite an Rückseite) die Positionierung erleichtert.
Deutlich sichtbar ist in Figur 8 auch die Trennung zwischen Rumpfbereich (4a) und Überstandsbereich (4b), sowie die Trennung zum randnahen Überlappungsbereiche und zum Überlappungsbereich, der an die Rückwand angrenzt. Weiterhin ist hier beispielhaft der Kabelquerschnitt (30) einer möglichen Kabelabführung an der Unter- bzw. an der Oberseite der Anschlussdose eingezeichnet.

## Patentansprüche

1. PV-Modul, das besonders kostengünstig transportiert werden kann, wobei das Modul eine rechteckige Rückwand und eine rechteckige transparente Frontscheibe mit der Ausdehnung X von links nach rechts und der Ausdehnung Y von unten nach oben besitzt, die einen rechten, einen linken, einen unteren und einen oberen Rand besitzt, bei der ein Zentralpunkt durch die Mitte der Vorderfläche der Frontscheibe definiert ist,
und wobei zwischen Frontscheibe und Rückwand eine aktive Schicht liegt, in der unter anderem Photovoltaik Zellen eingebaut und elektrisch verschaltet sind wobei das gesamte Laminat aus Frontscheibe aktiver Schicht und Rückwand eine Dicke Z aufweist
wobei der linke Rand der Frontscheibe in jeweils 4 Bereiche eingeteilt ist, die von oben nach unten mit 11, 12, 13 und 14 bezeichnet werden, und wobei der rechte Rand der Frontscheibe ebenfalls in vier Bereiche eingeteilt ist, die von oben nach unten mit 21, 22, 23 und 24 bezeichnet werden, wobei die Bereiche 14, 21, und 24 ebenso groß sind wie der Bereich 11, und die Bereiche 13, 22 und 23 ebenso groß sind wie der Bereich 12 und wobei das Modul über eine Anschlussdose für den Pluspol und eine Anschlussdose für den Minuspol verfügt, von denen eine Dose in einem der vier linken Randbereiche und eine Dose in einem der vier rechten Randbereiche angeordnet ist und die Anschlussdosen nach rechts und nach links über den Rand der Frontscheibe hinausragen,
**dadurch gekennzeichnet,**
**dass** die beiden Dosen in den Bereichen 11 und 22 oder 11 und 23 oder 12 und 21 oder 12 und 24 oder 13 und 21 oder 13 und 24 oder 14 und 22 oder 14 und 23 in Kombination angeordnet sind.

2. PV-Modul nach Anspruch 1 **dadurch gekennzeichnet, dass**
die Anschlussdosen jeweils aneinander angrenzend einen Rumpfbereich, eine Überstandsbereich, einen randnahen Überlappungsbereich sowie einen an die Rückwand angrenzenden Überlappungsbereich besitzt, wobei der an die Rückwand angrenzende Überlappungsbereich maximale die Dicke von Rückwand und Mittelschicht zusammen erreicht, und
der randnahe Überlappungsbereich maximal die doppelte Dicke von Rückwand und aktiver Schicht erreicht und
die Dicke im Überstandsbereich maximal die Moduldicke zuzüglich der Dicke der Rückwand und zuzüglich der Dicke der aktiven Schicht erreicht und die Dicke im Rumpfbereich maximale die Dicke eines Quartetts von Modulen einschließlich Trennblätter erreicht.

3. Verfahren zum Transport wenigstens zweier PV-Module nach Anspruch 1, **dadurch gekennzeichnet, dass**
für den Transport und eine platzsparende Verpackung der Module, zwei der Module ein Modulpaar bilden, wobei eines von zwei zunächst gleich ausgerichteten Modulen um 180° gedreht wird,
entweder um die Achse, die vertikal durch den Zentralpunkt des Moduls geht oder um die Achse, die horizontal durch den Zenträlpunkt des Moduls geht,
und die beiden Module Rückseite an Rückseite vollflächig aneinander gelegt werden, wobei optional ein Trennblatt zwischen die beiden Module gelegt wird.

4. Verfahren nach Anspruch 3, **dadurch gekennzeichnet, dass**
für den Transport und eine platzsparende Verpackung der Module zwei gleichartig aufgebaute und zunächst gleich orientierte Modulpaare ein Modulquartett bilden, wobei eines der Modulpaare um eine Achse die von vorne nach hinten durch den Zentralpunkt verläuft um 180° gedreht wird und die beiden Modulpaare aneinander gelegt werden, so dass die Vorderflächen zweier Module aufeinanderliegen, wobei optional ein Trennblatt zwischen die beiden Paare gelegt wird.

5. Verfahren nach Anspruch 3, **dadurch gekennzeichnet, dass**
die rechteckige Rückwand des Moduls nach rechts und links eine geringere Ausdehnung hat als die Frontscheibe und dass der Bereich in dem hinter der Frontscheibe keine Rückwand liegt als Übergangsbereich bezeichnet wird, und dass in den am rechten und am linken Rand der Frontscheibe anliegenden Übergangsbereichen Teile der Anschlussdosen angebracht sind.

## Claims

1. PV module that can be transported particularly cost-effective, **characterized in that** the module has a rectangular rear wall and a rectangular transparent front panel with the extent X from left to right and the extent Y from bottom to top,
having a right, a left, a lower and has an upper edge, and having a central point which is defined by the center of the front surface of the front panel, and that between the front panel and rear wall, there is an active layer, where inter alia, the photovoltaic cells are installed and electrically interconnected
and whereby the entire laminate consisting of front panel, active layer and rear wall has a thickness Z
and whereby the left edge of the front panel is divided into four areas, which are designated from top to bottom with 11, 12, 13 and 14 and whereby the right edge of the front panel is also divided into four areas, designated from top to bottom with 21, 22, 23 and 24, whereby the areas 14 , 21, and 24 have the same size as the area 11, and the areas 13, 22 and 23 have the same size as the area 12
and the module has a positive pole junction box and a negative pole junction box, one of which is arranged in one of the four left edge areas and the other in one of the four right edge areas and the junction boxes exceed over the right and over the left edge of the front panel,
**characterized in that** the two junction boxes are located combined in the areas 11 and 22 or in the areas 11 and 23 or in the areas 12 and 21 or in the areas 12 and 24 or in the areas 13 and 21 or in the areas 13 and 24 or in the areas 14 and 22 or in the areas 14 and 23.

2. PV module according to claim 1, **characterized in that**
a junction boxes consists of four areas each adjacent to each designated as "main body area", "supernatant area", "overlap area near the edge" and "overlapping area adjoining the rear wall", wherein
the junction box in the "overlapping area adjoining the rear wall" has a maximum thickness of the back wall and active layer together, and
the junction box in the "overlap area near the edge" reaches a maximum thickness of twice the thickness of the rear wall together with the active layer and
the junction box in the "supernatant area" reaches a maximum thickness of the module thickness plus the thickness of the rear wall plus the thickness of the active layer, and
the junction box in the "main body area" reaches a maximum thickness of a quartet of modules including separation sheets.

3. Method for transporting at least two PV modules according to claim 1, **characterized in that**
for the transport and a space-saving packaging of the modules, two of the modules form a module pair, wherein one of two initially equal aligned modules is rotated by 180 °, either about the axis, going vertically through the central point of the module or around the axis, which goes horizontally through the central point of the module, and the two modules are placed back to back over the whole module area, with an optional separation sheet is placed between the two modules.

4. Method according to claim 3, **characterized in that** for transport and space-saving packaging of the modules two identically constructed and initially equal oriented module pairs form a "modulquartett" wherein one of the pairs of modules is rotated by 180 ° about an axis which runs from front to back through the central point and the two pairs of modules are placed against each other, so that the front surfaces of two modules lie on top of each other, with optionally a separator sheet is placed between the two pairs.

5. Method according to claim 3, **characterized in that** the rectangular rear wall of the module to the right and left edge has a smaller extent than the front panel and that the area behind the front panel where no rear wall is present is denoted as a transition region, and that a part of one junction box is attached to the transition region at the left edge and a part of the other junction box is attached to the transition region of the right edge.

## Revendications

1. Module PV qui peut être transporté à un coût particulièrement bas, où le module a une paroi arrière rectangulaire et un panneau frontal transparent rectangulaire avec l'extension X de gauche à droite et l'extension Y de bas en haut, qui a un droit, a un bord gauche, un bord inférieur et un bord supérieur, dans lequel un point central est défini par le centre de la surface avant du panneau frontal,
et dans lequel entre le panneau frontal et la paroi arrière est une couche active, dans laquelle, entre autres, des cellules photovoltaïques intégrées et électriquement vercommutées sont où le stratifié entier de la couche active du panneau avant et de la paroi arrière a une épaisseur Z
dans lequel le bord gauche du panneau frontal est divisé en quatre zones, qui sont désignées de haut en bas avec 11, 12, 13 et 14, et dans lequel le bord droit du pare-brise est également divisé en quatre zones, le haut en bas, 21, 22, 23 et 24, dans lequel les zones 14, 21 et 24 sont aussi grandes que la zone 11, et les zones 13, 22 et 23 sont aussi grandes que la zone 12,
et dans lequel le module dispose d'une prise pour la borne positive et une prise pour le pôle négatif, dont l'une est située dans l'une des quatre régions de bord gauche et une dans l'une des quatre régions de bord droit, et une prise à droite et une prise à gauche faire saillie le bord du pare-brise, caractérisé
que les deux boîtes sont agencées en combinaison dans les zones 11 et 22 ou dans les zones 11 et 23 ou dans les zones 12 et 21 ou dans les zones 12 et 24 ou dans les zones 13 et 21 ou dans les zones 13 et 24 ou dans les zones 14 et 22 ou dans les zones 14 et 23.

2. Module PV selon la revendication 1, **caractérisé en ce que**
les boîtes de jonction chacune adjacente l'une à l'autre a une région de corps, une région de surnageant, une région de chevauchement près du bord et une région de chevauchement adjacente à la paroi arrière, dans laquelle
la zone de chevauchement adjacente à la paroi arrière atteint le maximum des épaisseurs de la paroi arrière et de la couche intermédiaire, et
la zone de chevauchement près du bord a atteint un maximum de deux fois l'épaisseur de la paroi arrière et de la couche active et
l'épaisseur dans la région de surnageant atteint au plus l'épaisseur du module plus l'épaisseur de la paroi arrière plus l'épaisseur de la couche active, et
l'épaisseur dans la région de corps atteint l'épaisseur maximale d'un quatuor de modules, y compris les diviseurs.

3. Procédé de transport d'au moins deux modules photovoltaïques selon la revendication 1, **caractérisé en ce que** deux des modules forment pour le transport et l'encombrement des modules une paire de modules, l'un des deux modules initialement alignés étant tourné de 180 °, soit autour de l'axe qui passe verticalement par le centre du module ou autour de l'axe passant horizontalement par le centre du module, et les deux modules sont placés côte à côte à l'arrière du module, éventuellement avec une feuille séparatrice entre les deux modules.

4. Procédé selon la revendication 3, **caractérisé en ce que** deux paires de modules de construction identique et orientées à l'identique forment un module Modulquartett pour le transport et l'encombrement des modules, l'une des paires de modules tournant autour de 180 ° de l'avant vers l'arrière. et les deux paires de modules sont placées l'une contre l'autre, de sorte que les surfaces frontales des deux modules se trouvent l'une sur l'autre, avec éventuellement une feuille séparatrice placée entre les deux paires.

5. Procédé selon la revendication 3, **caractérisé en ce que** la paroi arrière rectangulaire du module à droite et à gauche a une plus petite étendue que le panneau frontal transparent et que la zone dans laquelle derrière le panneau frontal aucune paroi arrière est appelée la zone de transition, et que dans le bord droit et gauche des zones de transition les boîtes de jonction sont attachées.
